# EUROPÄISCHE PATENTSCHRIFT

(11) **EP 1 203 382 B1**
(45) Veröffentlichungstag und Bekanntmachung des Hinweises auf die Patenterteilung: **17.08.2005**
(21) Anmeldenummer: 00949391.7
(22) Anmeldetag: 21.07.2000
(51) Int. Cl.: H01F 41/30, H01F 10/32, H01L 43/12

(54) **VERFAHREN ZUR HERSTELLUNG EINES MAGNETISCHEN TUNNELKONTAKTES SOWIE MAGNETISCHER TUNNELKONTAKT**
METHOD FOR PRODUCING A MAGNETIC TUNNEL CONTACT AND MAGNETIC TUNNEL CONTACT
PROCEDE DE FABRICATION D'UN CONTACT TUNNEL MAGNETIQUE ET CONTACT TUNNEL MAGNETIQUE

(30) Priorität: 12.08.1999 DE 19938215
(43) Veröffentlichungstag der Anmeldung: 08.05.2002
(73) Patentinhaber: Forschungszentrum Jülich GmbH, 52425 Jülich (DE)
(72) Erfinder: KOHLSTEDT, Hermann, D-50170 Kerpen (DE); ROTTLÄNDER, Peter, 54600 Villers-lès-Nancy (FR)
(74) Vertreter: Paul, Dieter-Alfred, Dipl.-Ing.
(86) Internationale Anmeldenummer: PCT/EP2000/007012
(87) Internationale Veröffentlichungsnummer: WO 2001/013387

(56) Entgegenhaltungen:
- DE-A- 19 818 547
- BOBO J F ET AL: "SPIN-DEPENDENT TUNNELING JUNCTIONS WITH HARD MAGNETIC LAYER PINNING" JOURNAL OF APPLIED PHYSICS,US,AMERICAN INSTITUTE OF PHYSICS. NEW YORK, Bd. 83, Nr. 11, PART 02, 1. Juni 1998 (1998-06-01), Seiten 6685-6687, XP000777208 ISSN: 0021-8979
- FRITZSCH L ET AL: "Preparation of Nb/Al-AlOx/Nb Josephson junctions with critical current densities down to 1 A/cm" PHYSICA C,NL,NORTH-HOLLAND PUBLISHING, AMSTERDAM, Bd. 296, Nr. 3-4, 20. Februar 1998 (1998-02-20), Seiten 319-324, XP004129924 ISSN: 0921-4534 in der Anmeldung erwähnt
- KUMAGAI S ET AL: "Spin tunneling magnetoresistance in NiFe/Al2O3/Co junctions with reduced dimensions formed using photolithography" JOURNAL OF MAGNETISM AND MAGNETIC MATERIALS,NL,ELSEVIER SCIENCE PUBLISHERS, AMSTERDAM, Bd. 166, Nr. 1-2, 1. Februar 1997 (1997-02-01), Seiten 71-74, XP004115590 ISSN: 0304-8853
- BEECH R S ET AL: "SPIN DEPENDENT TUNNELING DEVICES FABRICATED USING PHOTOLITHOGRAPHY" IEEE TRANSACTIONS ON MAGNETICS,US,IEEE INC. NEW YORK, Bd. 32, Nr. 5, 1. September 1996 (1996-09-01), Seiten 4713-4715, XP000634114 ISSN: 0018-9464
- ROTTLANDER P ET AL: "Magnetic tunnel junctions prepared by ultraviolet light assisted oxidation" JOURNAL OF MAGNETISM AND MAGNETIC MATERIALS,NL,ELSEVIER SCIENCE PUBLISHERS, AMSTERDAM, Bd. 210, Nr. 1-3, Februar 2000 (2000-02), Seiten 251-256, XP004186778 ISSN: 0304-8853
- H.BOEVE ET AL: "Strongly reduced bias dependence in spin-tunnel junctions obtained by ultraviolet light assisted oxidation" APPLIED PHYSICS LETTERS., Bd. 76, Nr. 8, 21. Februar 2000 (2000-02-21), Seiten 1048-1050, XP000955205 AMERICAN INSTITUTE OF PHYSICS. NEW YORK., US ISSN: 0003-6951

## Beschreibung

Die Erfindung betrifft ein Verfahren zur Herstellung eines magnetischen Tunnelkontakts nach dem Oberbegriff des Anspruchs 1 sowie einen magnetischen Tunnelkontakt nach dem Oberbegriff des Anspruchs 4.

Derzeit werden mit großem Aufwand ferroelektrische und magnetoresistive Speichertechnologien entwickelt, deren Perspektive darin besteht, den Versorgungsspannungsabhängigen DRAM (dynamic random access memory) durch einen Versorgungsspannungs-unabhängigen, nicht-flüchtigen Speicherbaustein, bezeichnet als FRAM (ferroelectric random access memory) bzw. MRAM (magnetic random access memory), zu ersetzen.

Für MRAMs kommen verschiedene magnetoresistive Effekte in Betracht. AMR-(anisotrope magnetoresistance)Speicher beruhen darauf, daß der Widerstand für elektrische Ströme parallel und senkrecht zur Magnetisierungsrichtung eines Leitermaterials verschieden ist. Das GMR-(giant magnetoresistance)Speicherkonzept beruht auf dem Riesenmagnetowiderstandseffekt, welcher in Schichtstapeln, bestehend aus alternierend angeordneten nanometerdünnen magnetischen Schichten (z.B. aus Kobalt) und nicht-magnetischen Schichten (z.B. aus Kupfer), auftritt. Ein dritter Kandidat für MRAMs sind magnetische Tunnelkontakte. Sie bestehen aus zwei ferromagnetischen Schichten, die von einer dünnen Tunnel-Isolationsschicht getrennt sind.

Eine weiteres Anwendungsgebiet für auf magnetoresistive Effekte beruhende Bauelemente ist die Magnetfeld-Sensortechnologie. Derzeit sind bereits AMR-, GMR- und Tunnel-Magnetfeldsensoren bekannt.

Die Wirkungsweise von magnetischen Tunnelkontakten beruht auf einer spinabhängigen Änderung des Tunnelwiderstands (TMR: tunneling magnetoresistance) für normalleitende Elektronen, dem eine Spinpolarisation der beteiligten magnetischen Schichten zugrundeliegt. Bis vor kurzem hatte dieser Effekt nur Grundlagencharakter, da die beim spinabhängigen Tunneln gemessenen relativen Änderungen des Magnetowiderstands ΔR/R unter 1% lagen. Die Situation änderte sich 1995, nachdem T. Miyazaki, et al. in "Giant magnetic tunneling effect in Fe/Al₂O₃/Fe junction" J. Magn. Magn. Matter. 139, Seiten L231-L234, von magnetischen Tunnelkontakten mit Werten um ΔR/R ≥ 18% bei Raumtemperatur berichteten.

Ein wesentlicher Vorteil der magnetischen Tunnelkontakte besteht darin, daß sie hochohmig sind und daher eine bessere Kompatibilität mit bestehenden integrierten Halbleiterschaltungen aufweisen als die niederohmigen AMR- oder GMR-Elemente. Daher ist zu erwarten, daß magnetische Tunnelkontakte (als Speicher- oder Sensorelemente) beste Perspektiven für die Integration in kommende Chip-Generationen haben.

Für die Eignung eines magnetischen Tunnelkontaktes zum Einsatz in integrierten Schaltungen ist es erforderlich, daß dieser neben der bereits angesprochenen möglichst großen relativen Änderungen des Magnetowiderstands ΔR/R ein Widerstands-Flächen-Produkt RA aufweist, das optimalerweise im Bereich von 10² bis maximal etwa 10⁴ Ω x µm² liegen sollte. Magnetische Tunnelkontakte, die diese beiden Bedingungen gleichzeitig erfüllen, konnten bisher nicht hergestellt werden.

In der den nächstliegenden Stand der Technik repräsentierenden Schrift "Magnetic tunneling applied to memory", von J.M. Daughton, J. Appl. Phys. 81, Seiten 3758-3763 (1997), ist ein magnetischer Tunnelkontakt mit einer relativen Magnetowiderstandsänderung ΔR/R von 20% und einem Widerstands-Flächen-Produkt RA von 10 - 10⁶ kΩ x µm² angegeben. Zur Erzeugung der Tunnel-Isolationsschicht wird dabei eine 2,0 nm dicke partiell oxidierte Al-Schicht und darüber eine 0,6 nm dicke vollständig oxidierte Al₂O₃-Schicht eingesetzt. Es wird es als vorteilhaft erachtet, eine nicht vollständig oxidierte Metallschicht als magnetische Tunnelschicht einzusetzen.

In der Veröffentlichung "Bias voltage and temperature dependence of magnetotunneling effect", Yu Lu, et al., J. Appl. Phys., 83, Seiten 6515 - 6517, (1998), ist ein magnetischer Tunnelkontakt beschrieben, der eine oxidierte Aluminium-Schicht als Tunnel-Barriereschicht verwendet. Zur Herstellung der oxidierten Barriereschicht wird eine 0,5 bis 1,5 nm dünne Aluminium-Schicht auf der unteren ferromagnetischen Schicht des Tunnelkontaktes abgelagert und nachfolgend mit einem Plasma-Oxidationsverfahren oxidiert. Vorteilhaft bei der Plasma-Oxidationsmethode sind die kurzen Oxidationszeiten (30 Sekunden bis 7 Minuten) zur Herstellung der Isolationsschicht und die Möglichkeit, ausreichend hohe relative Magnetowiderstandsänderungen (mehr als 16 % bei Raumtemperatur) erzielen zu können. Nachteilig ist jedoch, daß die mit diesem Verfahren erzeugten magnetischen Tunnel-Isolationsschichten ein für die Integration in Halbleiterchips zu hohes Widerstands-Flächen-Produkt RA von über 50 kΩ x µm² aufweisen.

In der Veröffentlichung "Preparation of Nb/Al-AlOₓ/Nb Josephson junctions with critical current densities down to 1 A/cm²" von L. Fritzsch, et al., PHYSICA C 296, Seiten 319 - 324, (1998), wird ein Verfahren zur Erzeugung von Tunnel-Isolationsschichten für supraleitende Josephson-Tunnelkontakte beschrieben. Bei dem Verfahren wird eine 8 nm dicke Aluminium-Schicht auf einer Niob-Elektrode aufgebracht und mittels eines UV-Licht-unterstützten Oxidationsverfahrens in einem etwa 1,3 nm dicken Oberflächenschichtbereich vollständig oxidiert. Die Josephson-Tunnelkontakte müssen bei einer Temperatur unterhalb der Sprungtemperatur (9,2 K) des Niobs betrieben werden und basieren auf dem Tunneln von Cooper-Paaren bestehend aus zwei geparten Elektronen mit entgegengesetztem Spin. Über mögliche Anwendungen solcherart hergestellter Schichten außerhalb des Bereichs supraleitender Tunnelkontakte und insbesondere über ihre magnetischen Eigenschaften ist der Schrift nichts zu entnehmen.

Der Erfindung liegt die Aufgabe zugrunde, ein Verfahren zur Herstellung eines magnetischen Tunnelkontaktes anzugeben, das mit üblichen in der Halbleitertechnologie verwendeten Prozessen kompatibel ist und es ermöglicht, einen magnetischen Tunnelkontakt mit für die Integration in Halbleiterschaltungen günstigen elektrischen Eigenschaften zu schaffen. Ferner zielt die Erfindung darauf ab, einen magnetischen Tunnelkontakt zu schaffen, der zur Anwendung in zukünftigen Halbleiterschaltungen, insbesondere in Form eines MRAM oder Magnetfeldsensors, geeignet ist.

Die Erfindung wird durch die Merkmale der Ansprüche 1 und 4 gelöst.

Durch die Verwendung des UV-Licht-unterstützten Oxidationsverfahrens können magnetische Tunnelkontakte geschaffen werden, die bei 300 K eine relative Magnetowiderstandsänderung von mehr als 10 % (und bei ersten Versuchen bis zu 22%) und ein Widerstands-Flächen-Produkt RA von weniger als 10 kΩ x µm², insbesondere weniger als 2 kΩ x µm² (und bei ersten Versuchen bis zu 0,3 kΩ x µm²) aufweisen. Somit lassen sich durch das erfindungsgemäße Verfahren magnetische Tunnelkontakte mit einer guten Empfindlichkeit (d.h. mit einem großen relativen Magnetowiderstandsverhältnis ΔR/R) und Werten für das Widerstands-Flächen-Produkt RA herstellen, die für MRAM-Anwendungen in bezug auf Schaltgeschwindigkeit und Kompatibilität zu CMOS-Ausleseschaltungen optimal sind.

Es wird angenommen, daß der Erfolg des erfindungsgemäßen Verfahrens darauf zurückzuführen ist, daß das Oxidationsverfahren einerseits eine nahezu stöchiometrische Oxidation des Metalls ohne zurückbleibende, nicht-oxidierte Metallanteile ermöglicht und andererseits - im Gegensatz zu dem im Stand der Technik bekannten, aggressiven Plasma-Oxidations(ätz)verfahren - einen präzisen selbstbegrenzenden Oxidationsstop an der Grenzfläche zu dem darunterliegenden ferromagnetischen Material aufweist.

Ein weiterer Vorteil des erfindungsgemäßen Verfahrens besteht darin, daß es trotz der relativ "sanften" Oxidation ausreichend schnell ausführbar ist, um vom Zeitablauf her in Halbleiter-Herstellungsverfahren integriert werden zu können. Da Metallablagerungs- und Oxidationsschritte in der Halbleitertechnologie schon seit langem eingesetzt werden, treten auch bei der prozeßtechnologischen Integration des Verfahrens keine Schwierigkeiten auf.

Vorzugsweise wird bei der Ablagerung der Metallschicht deren Schichtdicke auf maximal etwa 2 nm eingestellt. Dadurch wird sichergestellt, daß die abgelagerte Metallschicht vollständig (d.h. nicht nur stöchiometrisch sondern auch durch die gesamte Schicht hindurch) oxidiert wird. Es hat sich herausgestellt, daß nicht-oxidierte Metallanteile in der Isolationsschicht nach Möglichkeit vermieden werden müssen, da sie die Erzielung niedriger Werte für das Widerstands-Flächen-Produkt erschweren. Das Material der Metallschicht ist vorzugsweise Al, Mg, Hf, Ta, Zr, Y oder Er.

Eine weitere vorteilhafte Maßnahme kennzeichnet sich dadurch, daß der Tunnelkontakt durch einen Lithographie- und Ionenstrahlätzschritt in insbesondere elliptischer Form strukturiert wird. Über die Formanisotropie wird eine magnetisch leichte Achse definiert, die bewirkt, daß magnetische Domänen eine Vorzugsrichtung entlang der langen Achse der Ellipse einnehmen.

Mit besonderem Vorteil kommt der erfindungsgemäße magnetische Tunnelkontakt in einer Speicherzelle und/oder in einem Magnetfeldsensor zum Einsatz.

Weitere vorteilhafte Ausgestaltungen der Erfindung sind in den Unteransprüchen angegeben.

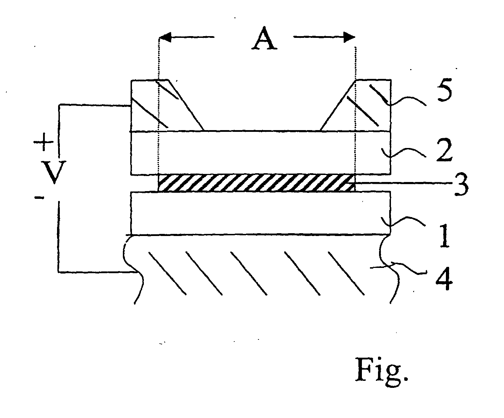

Die Erfindung wird nachfolgend anhand eines Ausführungsbeispiels unter Bezugnahme auf die Zeichnung erläutert; in dieser zeigt die einzige Figur eine schematische Schnittdarstellung eines magnetischen Tunnelkontaktes.

Der Tunnelkontakt weist eine untere hartmagnetische Schicht, beispielsweise Co-Schicht 1, eine obere weichmagnetische Schicht, beispielsweise NiFe-Schicht 2, und eine zwischen den beiden ferromagnetischen Schichten 1, 2 angeordnete Tunnel-Isolationsschicht 3 auf. Die Tunnel-Isolationsschicht 3 besteht vorzugsweise vollständig aus stöchiometrischem Al₂O₃ und wird in der noch zu beschreibenden Weise hergestellt. Unterhalb der hartmagnetischen unteren Schicht 1 und oberhalb der weichmagnetischen oberen Schicht 2 sind Metallisierungen 4, 5 aufgebracht, über die der magnetische Tunnelkontakt 1, 2, 3 elektrisch kontaktiert wird. Die elektrische Kontaktierung wird in der dargestellten Weise über eine äußere Beschaltung realisiert, mittels welcher eine Spannung V vorgegebener Höhe an die Metallisierungen 4, 5 und damit an den Tunnelkontakt 1, 2, 3 angelegt werden kann.

Der mittels der Beschaltung meßbare elektrische Widerstand des magnetischen Tunnelkontaktes 1, 2, 3 wird mit R und seine Querschnittsfläche wird mit A bezeichnet. Mit ΔR wird die Differenz der elektrischen Widerstände bei antiparalleler zu paralleler magnetischer Ausrichtung der beiden ferromagnetischen Schichten 1, 2 bezeichnet. Die relative Magnetowiderstandsänderung ΔR/R = (R↑↓ -R↓↓)/R↓↓ ist auf den Kontaktwiderstand R↓↓ bei paralleler Ausrichtung der ferromagnetischen Schichten 1, 2 bezogen. Sämtliche angegebenen Werte beziehen sich auf Raumtemperatur (300 K).

Die erfindungsgemäße Herstellung des Tunnelkontaktes 1, 2, 3 ist wie folgt:

Zunächst wird auf der Grundmetallisierung 4 die untere hartmagnetische Co-Schicht 1 abgeschieden. Anstelle von Co können auch andere ferromagnetische Materialien wie beispielsweise Fe sowie Legierungen ferromagnetischer Materialien eingesetzt werden.

In einem nächsten Schritt wird auf die untere ferromagnetische Schicht 1 eine dünne Al-Schicht aufgesputtert. Die aufgesputterte Al-Schicht wird dann für etwa 30 Minuten einer Sauerstoff-Atmosphäre von etwa 10 mbar ausgesetzt, wobei eine Quecksilber-Niederdrucklampe zur Erzeugung der UV-Strahlung eingesetzt wird. Die UV-Strahlung bewirkt, daß molekularer Sauerstoff in hochreaktiven atomaren Sauerstoff und Ozon umgesetzt wird.

Die Oxidation sollte so durchgeführt werden, daß möglichst sämtliches abgelagertes Al vollständig oxidiert wird. Dies wird sicher erreicht, solange die Al-Schichtdicke nicht mehr als etwa 2 nm beträgt.

Ein weiterer bereits angesprochener Vorteil der erfindungsgemäßen Oxidationsmethode besteht darin, daß die Oxidation an der Grenzfläche zu der darunterliegenden ferromagnetischen Schicht 1 selbstbegrenzend stoppt. Dies scheint eine Voraussetzung zu sein, um hochqualitative magnetische Tunnelkontakte mit Widerstands-Flächen-Produkten RA von weniger als 10 kΩ x µm² bei relativen Magnetowiderstandsänderungen von mehr als 10 % (bei 300 K) herstellen zu können.

Im Ergebnis überwindet das erfindungsgemäße Oxidationsverfahren sämtliche bei den bisher eingesetzten Oxidationsmethoden auftretende Probleme: Die rein thermische Oxidation führt zwar zu ausreichend kleinen Widerstands-Flächen-Produkten RA, ist jedoch für industrielle Anwendungen zu langsam und ermöglicht nur relativ geringe relative Magnetowiderstandsänderungen unterhalb 6 %. Die eingangs angesprochene Plasma-Oxidationsmethode ist zwar mit den bei der Serienfertigung auftretenden Zeitabläufen kompatibel, führt jedoch zu Widerstands-Flächen-Produkten RA von über 50 kΩ x µm².

In der Veröffentlichung "Voltage dependence of magnetoresistance in spin dependent tunneling junctions", J. Zhang and R. M. White, J. Appl. Phys. 83, 6512 (1998) wird erläutert, daß sogenannte "traps" in der Tunnelbarriere zu einer drastischen Abnahme von ΔR/R gegenüber der angelegten Biasspannung führen. Im Falle der Plasmaoxidation ist zu erwarten, daß viele Traps in die Barriere eingebaut werden, da während der Plasmaoxidation die Barriere hochenergetischen Teilchen >20 eV ausgesetzt ist. Im Gegensatz dazu führt eine thermische Oxidation (mit oder ohne UV-Licht) zu einer wesentlich reduzierten Anzahl von Traps in der Barriere. Damit ist zu erwarten, daß die Biasabhängigkeit in diesem Fall weit weniger stark ausgeprägt ist als im Falle der plasmaoxidierten Barrieren.

Thermisch oxidierte Barrieren haben deshalb den Vorteil, daß es möglich wird, die Tunnelkontakte im Biasbereich von 200 mV bis 3 V zu betreiben, ohne daß der magnetoresistive Effekt für die Ankopplung an die Halbleiterschaltungen zu klein wird.

Spannungen zwischen 200 mV bis 3 V sind ideal für die Signalverarbeitung innerhalb der Halbleiterausleseschaltungen.

Nach dem Oxidationsschritt wird die obere weichmagnetische NiFe-Schicht 2 aufgebracht. Die Schichtabscheidung kann mittels Ionenstrahlverdampfen oder Sputtern erfolgen.

Schließlich wird in einem weiteren Schritt der magnetische Tunnelkontakt 1, 2, 3 unter Einsatz von lithographischen Metallmaskentechniken und Ionenstrahlätzen strukturiert.

Bei im Rahmen der Erfindung durchgeführten Versuche wurden Tunnelkontakte 1, 2, 3 mit Flächen zwischen 10 µm² und 400 µm² hergestellt. Es konnten (bei Raumtemperatur) beispielsweise Widerstands-Flächen-Produkte RA um 300 Ω x µm² und relative Magnetowiderstandsänderungen ΔR/R von bis zu 22 % gemessen werden. Tunnelkontakte mit RA = 2kΩ x µm², die für die genannten Anwendungen besonders geeignet erscheinen, zeigten relative Widerstandsänderungen, die stets über 10% lagen. Kerr-Messungen zeigten eine klare Trennung der Koeerzitivfelder von der oberen NiFe-Schicht 2 und der unteren Co-Schicht 1. Für Co (hartmagnetisch) wurde ein Koeerzitivfeld von 15 mT und für NiFe (weichmagnetisch) ein entsprechender Wert von etwa 0,8 mT bestimmt.

## Patentansprüche

1. Verfahren zur Herstellung eines magnetischen Tunnelkontakts,
bei dem
- auf eine erste ferromagnetische Schicht (1) eine Metallschicht abgelagert und zur Erzeugung einer Isolationsschicht (3) oxidiert wird, und
- auf der Isolationsschicht (3) eine zweite ferromagnetische Schicht (2) erzeugt wird,
**dadurch gekennzeichnet,**
- **daß** die Oxidation der Metallschicht durch UV-Licht unterstützt wird.

2. Verfahren nach Anspruch 1, **dadurch gekennzeichnet, daß** bei der Ablagerung der Metallschicht, insbesondere Al-Schicht, deren Schichtdicke auf maximal 2 nm eingestellt wird.

3. Verfahren nach Anspruch 1 oder 2, **dadurch gekennzeichnet, daß** der Tunnelkontakt (1, 2, 3) durch einen Lithographie- und Ionenstrahl-Ätzschritt insbesondere in elliptischer Form strukturiert wird.

4. Magnetischer Tunnelkontakt, mit einer ersten (1) und einer zweiten (2) ferromagnetischen Schicht, zwischen welchen eine Tunnel-Isolationsschicht (3) bestehend aus einer Metalloxidschicht angeordnet ist, **dadurch gekennzeichnet, daß** der magnetische Tunnelkontakt (1, 2, 3)
- eine relative Magnetowiderstandsänderung ΔR/R von mehr als 10% bei 300 K und
- ein Widerstands-Flächen-Produkt RA von weniger als 10kΩ x µm², insbesondere 2kΩ x µm² aufweist.

5. Magnetischer Tunnelkontakt nach Anspruch 4, **dadurch gekennzeichnet, daß** das Widerstands-Flächen-Produkt RA im Bereich von etwa 300 Ω x µm² liegt.

6. Magnetischer Tunnelkontakt nach einem der Ansprüche 4 oder 5, **dadurch gekennzeichnet, daß** das Material der Metallschicht wahlweise Al, Mg, Hf, Ta, Zr, Y oder Er ist.

7. Magnetischer Tunnelkontakt nach einem der Ansprüche 4 bis 6, **dadurch gekennzeichnet, daß** der Tunnelkontakt (1, 2, 3) eine elliptische Form aufweist.

8. Speicherzelle, enthaltend einen magnetischen Tunnelkontakt (1, 2, 3) nach einem der vorhergehenden Ansprüche.

9. Magnetfeldsensor, enthaltend einen magnetischen Tunnelkontakt (1, 2, 3) nach einem der vorhergehenden Ansprüche.

## Claims

1. A method of producing a magnetic tunnel contact in which a metal layer is deposited on a first ferromagnetic layer (1) and is oxidized to produce an insulating layer (3), and on the insulation layer (3) a second ferromagnetic layer (2) is formed, **characterized in that** the oxidation of the metal layer is supported by UV light.

2. The method according to claim 1 **characterized in that** in the deposition of the metal layer, especially an aluminum layer, a layer thickness of a maximum of 2 nm is adjusted.

3. The method according to claim 1 or 2 **characterized in that** the tunnel contact (1, 2, 3) is structured by a lithographic step and an ion beam etching step especially in an elliptical shape.

4. A magnetic tunnel contact with a first (1) and a second (2) ferromagnetic layer, between which a tunnel insulating layer (3) comprised of a metal oxide layer is arranged, **characterized in that** the magnetic tunnel contact (1, 2, 3) has a relative magnetoresistance change ΔR/R of greater than 10% at 300 K and a resistance-area product RA of less than 10kΩ x µm , especially 2kΩ x µm.

5. The magnetic tunnel contact according to claim **characterized in that** the resistance area product RA lies in the range of about 300Ω x µm.

6. The magnetic tunnel contact according to one of claims 4 or 5 **characterized in that** the material of the metal layer is selectively Al, Mg, Hf, Ta, Zr, Y or Er.

7. The magnetic tunnel contact according to one of claims 4 to 6 **characterized in that** the tunnel contact (1, 2, 3) has an elliptical shape.

8. A memory cell containing a magnetic tunnel contact (1, 2, 3) according to one of the preceding claims.

9. A magnetic field sensor containing a magnetic tunnel contact (1, 2, 3) according to one of the preceding claims.

## Revendications

1. Procédé de fabrication d'un contact magnétique tunnel, où
- sur une première couche ferromagnétique (1) est déposée une couche de métal qui est oxydée pour l'obtention d'une couche isolatrice (3), et
- sur la couche isolatrice (3) est créée une seconde couche ferromagnétique (2), **caractérisé en ce que**,
- l'oxydation de la couche de métal a lieu en utilisant la lumière UV.

2. Procédé selon la revendication 1, **caractérisé en ce qu'**au dépôt de la couche de métal, spécialement la couche en Al, l'épaisseur de celle-ci est établie au maximum 2 nm.

3. Procédé selon la revendication 1 ou 2, **caractérisé en ce que**, le contact tunnel (1, 2, 3) est structuré spécialement dans une forme elliptique, par une étape de corrosion par lithographie et fascicule d'ions.

4. Contact magnétique tunnel, avec une première (1) et une seconde (2) couche ferromagnétique, entre lesquelles est disposée une couche isolatrice de tunnel (3) consistant en une couche d'oxyde de métal, **caractérisé en ce que**, le contact magnétique tunnel (1, 2, 3) présente
- une modification relative de la résistance magnétique ΔR/R plus de 10% à 300 K et
- un produit de résistance-surface RA plus petite de 10 kΩ x µm², spécialement 2 kΩ x µm².

5. Contact magnétique tunnel selon la revendication 4, **caractérisé en ce que**, le produit de résistance-surface RA est situé autour la valeur de 300 Ω x µm².

6. Contact magnétique tunnel selon l'une des revendications 4 ou 5, **caractérisé en ce que**, le matériau de la couche de métal est au choix Al, Mg, Hf, Ta, Zr, Y ou Er.

7. Contact magnétique tunnel selon l'une des revendications 4 à 6, **caractérisé en ce que**, le contact tunnel (1, 2, 3) présente une forme elliptique.

8. Cellule de mémoire, incluant un contact magnétique tunnel (1, 2, 3) selon l'une des revendications antérieures.

9. Senseur de champ magnétique, incluant un contact magnétique tunnel (1, 2, 3) selon l'une des revendications antérieures.
